# EUROPEAN PATENT APPLICATION

(11) **EP 1 508 754 A1**
(43) Date of publication of application: **23.02.2005**
(21) Application number: 03445096.5
(22) Date of filing: 15.08.2003
(51) Int. Cl.: F24F 11/053

(54) **Method and device for temperature control in a space containing electric equipment**

(71) Applicant: Ingenjörsfirma Kontrollelektronik Hjärtström & Kalén Aktiebolag, 614 31 Söderköping (SE)
(72) Inventor: Hjärtström, Torsten, 613 75 Norrköping (SE); Kalén, Hans, 614 90 Söderköping (SE)
(74) Representative: Andersson, Björn E.

(57) **Abstract**

A device for temperature control in a space containing technical equipment comprises an air inlet; an air filter arranged to filter air taken in through the air inlet; air outlets discharging in the space containing technical equipment; and fans arranged in a flow path between the air inlet and the air outlets. The air filter, the air outlets, and the fans are arranged in the device together with a controller and a power supply. The controller is arranged to control the fans, and the power supply is arranged to power supply the controller, the fans, and technical equipment contained in the space. Further, a method for temperature control in the space comprises the steps of: taking in air through an air inlet; filtering the air with an air filter; distributing the air in the space through air outlets; controlling fans with a controller; and supplying power to the controller, the fans and technical equipment contained in the space by a power supply. Said steps of taking in, filtering, distributing, controlling, and supplying power are performed by one single device that comprises said air inlet, air filter, air outlets, fans, controller, and power supply.

## Description

The present invention relates to a device for temperature control in a space for technical equipment, and an associated method.

### Background

Technical equipment that needs to be distributed over a wide area, e.g. electricity distribution plants, railway signal towers, telephone exchanges and radio base stations, is often placed in a shelter or a room in an existing building. The distributed plants are often called "sites". Within an electricity supply network, a railway network or a telephone network, there is a great number of sites. E.g. in a mobile telecommunication system, a plurality of base stations, or as called within UTRAN (UMTS Radio Access Network (Universal Mobile Telecommunication System)), Node Bs, has to be distributed over the entire coverage area of the mobile communication system. To be able to cover a country, a mobile telecommunication operator has to distribute maybe a couple of thousands of base stations, and as traffic load in the network increases, more base stations have to be distributed to increase capacity of the mobile communication network. As an example, a radio base station within a mobile telecommunication network needs power supply, connection terminals for connecting to telecommunication network and aerial, matching circuits, backup power supply, etc. All of these pieces of equipment will only work properly within a prescribed temperature range, e.g. between 10 and 50 degrees centigrade. Therefore, an arrangement for keeping the temperature within the shelter or room is also needed. To prevent the temperature from sinking below 10 degrees centigrade, an electric heater is normally used. To prevent the temperature from exceeding more than 50 degrees centigrade, a ventilation or air condition system is used. The electric heater and the ventilation or air condition system are normally installed in the shelter or room, as would be done in an ordinary building. An advantage of this is that every site can be customized.

The multitude of sites together with the physical requirements on the sites generate high costs for building up and maintenance. Further, maintenance is often impeded since there is a lot of different equipment placed in different sites.

### Summary of the invention

An object of the present invention is to overcome the above described problems of the known technologies in regards to building up and maintaining sites comprising technical equipment. The present invention is based on the understanding that sites comprising technical equipment have a basic physical requirement. It is further based on the understanding that if a more industrial approach is applied to the build up, costs will be significantly reduced, and maintenance will be streamlined, thus reducing also the maintenance costs.

It is further an object of the present invention to provide a device with integrated temperature control and power supply for use in a site comprising technical equipment.

A particular advantage of the present invention is cost, space and maintenance reduction. A further advantage of the invention is reduced energy consumption. Still an advantage is improved robustness, since necessary means for providing temperature control and power supply are always adapted to each other.

A particular feature of the present invention relates to the provision of an apparatus for temperature control and power supply that is common for all sites comprising technical equipment within a network. The network operator will then achieve lower costs and more robust sites.

The above objects, advantages and features together with numerous other objects, advantages and features, which will become evident from the detailed description below, are obtained according to a first aspect of the present invention by a device for temperature control in a space containing technical equipment, the device comprising
an air inlet;
an air filter arranged to filter air taken in through the air inlet;
one or more air outlets discharging in the space containing technical equipment;
one or more fans arranged in a flow path between the air inlet and said one or more air outlets, wherein
the air filter, said one or more air outlets, and said one or more fans are arranged in the device together with a controller and a power supply, wherein
the controller is arranged to control said one or more fans, and wherein
the power supply is arranged to power supply the controller, said one or more fans, and at least one piece of technical equipment contained in the space containing technical equipment.

The device according to the first aspect of the present invention may further comprise a heating means in the flow path between the air inlet and said one or more air outlets, or an air conditioning means.

The device according to the first aspect of the present invention may further comprise means for re-circulating at least a part of the air in the space for technical equipment. The means for re-circulation may comprise a damper for controlling the air flow, or when said one or more fans comprise two or more fans, said means for re-circulating at least a part of the air in the space for technical equipment may comprise said two or more fans, wherein at least one of said two or more fans is arranged to be driven at a lower speed than at least another of said two or more fans. The lower speed may be essentially zero, and the lower speed may also include that said at least one fan is driven in opposite direction compared to non-re-circulating operation.

The device according to the first aspect of the present invention may further comprise one or more temperature sensors measuring air temperature, wherein the controller controls said one or more fans depending on at least one output from said one or more temperature sensors.

According to the first aspect of the present invention, said at least one piece of technical equipment contained in the space containing technical equipment may comprise telecommunication equipment.

The device according to the first aspect of the present invention may further comprise any of the following means arranged to interact with technical equipment contained in the space containing technical equipment: a link transmission unit, a signal processing means, a matching circuit, a connection terminal board, and an antenna signal amplifier.

The device according to the first aspect of the present invention may further comprise a container arranged to keep a narrower temperature range compared to a temperature range kept in the space containing technical equipment. The container may comprise a peltier element for heating or cooling the interior of the container. A lead accumulator may be placed in the container. Other equipment that benefit from a narrower temperature range may also be placed in the container.

The power supply may comprise a network power supply and a backup power supply. The device and said at least one piece of technical equipment may be powered by the network power supply when operating in a first power supply mode, and the device and said at least one piece of technical equipment may be powered by the backup power supply when operating in a second power supply mode. The backup power supply may comprise one or more batteries, and said one or more batteries are charged by the network power supply when operating in the first power supply mode. The controller may be arranged to control power supply when operating in the second power supply mode, and to shut down equipment powered by the backup power supply in a controlled way if the backup power supply runs out of power.

The air inlet may be at a bottom of the device.

The above objects, advantages and features together with numerous other objects, advantages and features, which will become evident from the detailed description below, are obtained according to a second aspect of the present invention by a method for temperature control in a space containing technical equipment, the method comprising the steps of:
taking in air through an air inlet;
filtering the air with an air filter;
distributing the air in the space containing technical equipment through one or more air outlets by one or more fans;
controlling said one or more fans with a controller; and
supplying power to the controller, said one or more fans and at least one piece of technical equipment contained in the space for technical equipment by a power supply,
wherein said steps of taking in, filtering, distributing, controlling, and supplying power are performed by one single device that comprises said air inlet, air filter, one or more air outlets, one or more fans, controller, and power supply.

The method according to the second aspect of the present invention may further comprise the steps of:
measuring a first air temperature in the space for technical equipment;
heating air with a heater arranged in a flow path of the air flowing between the air inlet and said one or more air outlets if said first air temperature is below a first threshold level; and
distributing the heated air in the space for technical equipment with at least one of said one or more fans.

The method according to the second aspect of the present invention may further comprise the steps of:
measuring a second air temperature at the air inlet; and
re-circulating air from the space containing technical equipment if said second air temperature is below a second threshold level.

The method according to the second aspect of the present invention, wherein said one or more fans may comprise two or more fans, may further comprise the steps of:
driving one of said two or more fans at a lower speed; and
driving another one of said two or more fans at a higher speed.

The lower speed may be essentially zero. The lower speed may include that said at least one fan is driven in opposite direction compared to non-re-circulating operation.

The method according to the second aspect of the present invention, wherein the device may comprise a container, may further comprise the steps of:
controlling the temperature in the space containing technical equipment to be within a first temperature range; and
controlling the temperature in the container to be within a second temperature range, wherein the second temperature range is narrower than the first temperature range.

The term "first" and "second" should in this context entirely be construed as term for differentiating between two elements, and not be construed as a timing consideration.

### Brief description of the drawings

Further objects, features and advantages of the present invention will become apparent upon consideration of the following detailed description in conjunction with the appended drawings.
Fig 1 shows an exterior view of an example of a prior art site.
Fig 2 shows an example of an arrangement plan for a site shelter according to prior art.
Fig 3a shows a view from one side of one embodiment of a device according to the present invention.
Fig 3b shows a perpendicular view of the device shown in Fig 3a.
Fig 4 shows an example of an arrangement plan for a site shelter according to the present invention.
Fig 5 shows an exterior view of an example of a site according to the present invention.
Fig 6a schematically shows air flow in a device according to one embodiment of the present invention.
Fig 6b schematically shows another air flow option in a device according to one embodiment of the present invention.
Fig 6c schematically shows yet another air flow option in a device according to one embodiment of the present invention.
Fig 7 shows an alternative embodiment of a device according to the invention.

### Detailed description of embodiments

In the following description of the various embodiments, reference is made to the accompanying drawings which form a part hereof and which by way of illustration show various embodiments in which the invention may be practiced. It is to be understood that other embodiments may be utilised and structural and functional modifications may be made without departing from the scope of the present invention.

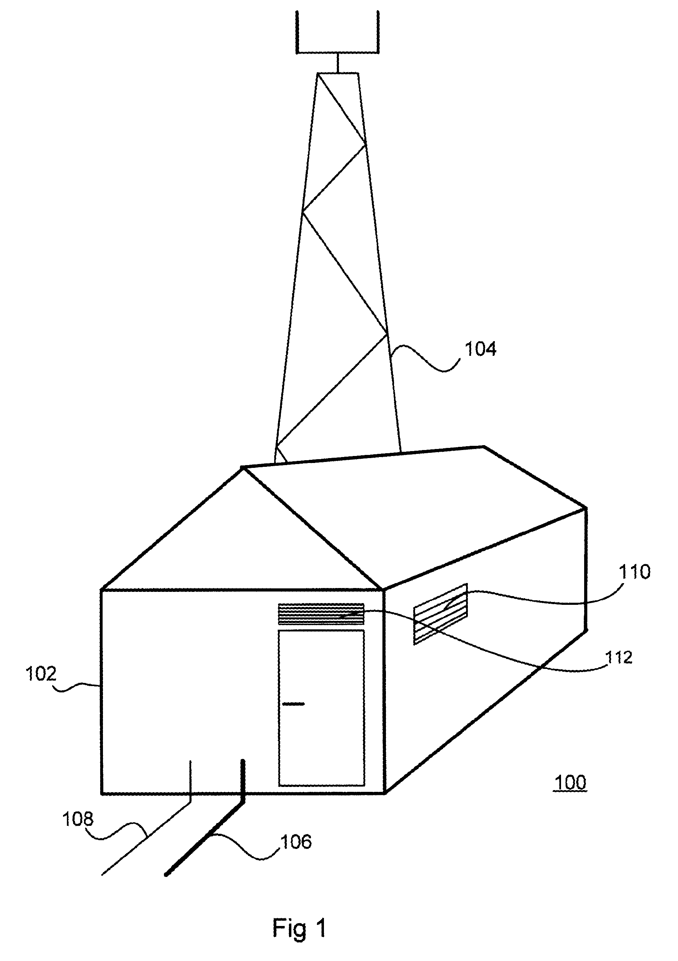

Fig 1 shows an example of a site 100 comprising a shelter 102 and some external equipment 104. In this particular example, a mobile communication base station site is depicted for illustrative reasons, with an antenna arrangement as external equipment. However, the same applies for most sites comprising technical equipment, e.g. electricity distribution plants, railway signal towers, telephone exchanges, transmission sites for radio and television broadcasting, private mobile radio network sites, radio repeaters and weather stations. All of these generally comprise some form of technical equipment inside a shelter and some external equipment. The technical equipment normally needs power supply. Therefore, the site has a connection to a power supply network 106. Further, for control, or input and output of information, the site has a connection to a communication network 108. In Fig 1 this is depicted as a wired connection for illustrative reasons. However, the connection may as well be wireless. The shelter normally needs some form of ventilation. Therefore, an air inlet 110 and an air outlet 112 are normally provided.

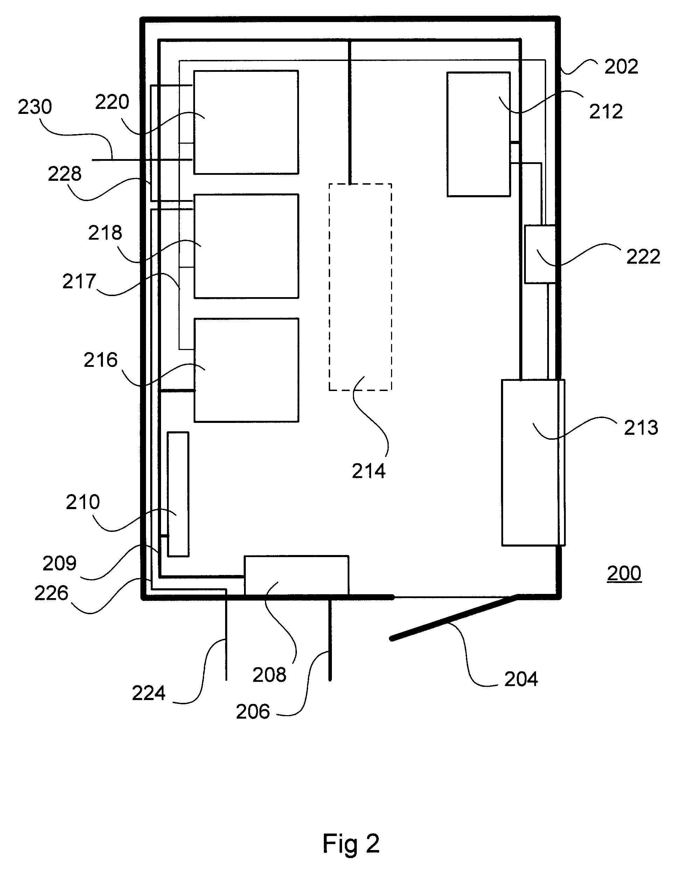

Fig 2 shows an arrangement plan for the shelter in the example of Fig 1. The shelter 200 may be built as a small house 202 with a door 204. A connection to power supply network supplies AC power to an AC distribution box 208, which distributes AC power over an internal AC power network 209 to e.g. heater 210, air conditioner 212, ventilation 213, light 214 and internal power supply 216. The internal power supply 216 provides DC power over an internal DC power network 217 to equipment requiring DC power, e.g. matching circuits 218, radio equipment 220 and temperature controller 222. A connection to a communication network 224 is connected at 226 to matching circuits 218. The technical equipment 218, 220 is interconnected by a communication line 228, which may comprise an internal communication network. In Fig 2 the technical equipment is represented by the matching circuits 218 and the radio equipment 220, but may of course be any technical equipment, and is not limited to only two devices. The radio equipment 220 has a connection 230 to external equipment, e.g. an antenna. However, as discussed above, the technical equipment and external equipment may be of any kind, still needing an interconnection 230 between them. The connection 230 is depicted as a wire, but may of course also be wireless when appropriate, e.g. a short link radio.

The site arrangement as described above with reference to Fig 1 and Fig 2 features high flexibility since all necessary parts are customised when building the site. However, the building costs are extensive. Further, a plurality of craftsmen has to be involved at every site. Since the sites may be located over a wide area, e.g. a country or a whole continent, and not seldom in places difficult to access, the more craftsmen that have to be involved in building up the site, the more problems with planning and logistics show up in the building process, and thus high costs. Further, the more constellations at different sites in a network, the more problems when maintaining the sites. Of course, this can be solved by precise specifications for every site within a network, but the high building up costs stated above remain.

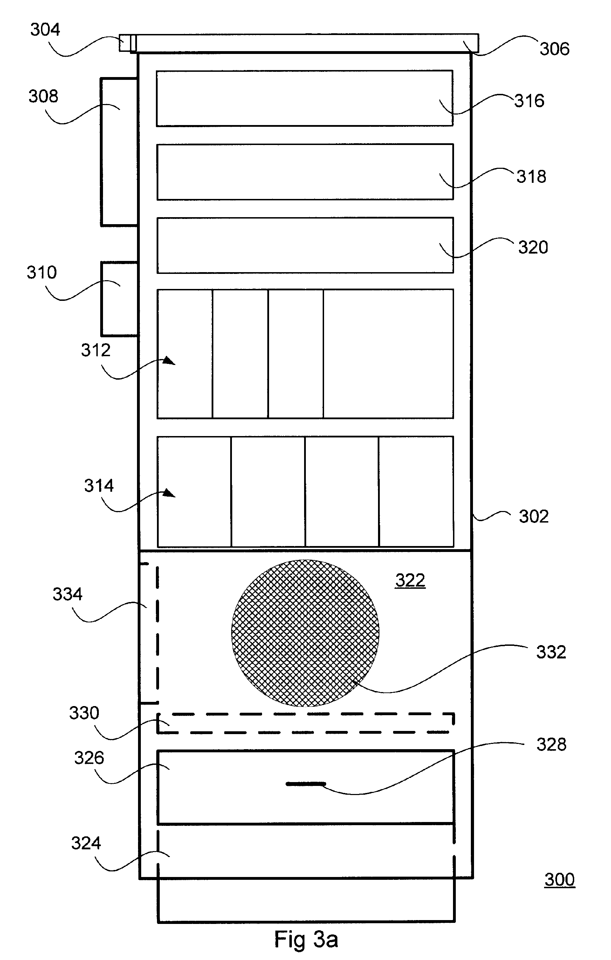

Fig 3a shows a device 300 according to one embodiment of the present invention. A framework 302 on which the device 300 is built up is a cabinet for e.g. 19" rack. The framework 302 may hold lighting devices 304, 306, AC distribution box 308, controller 310, DC power supplies 312, DC power backup batteries 314, miscellaneous circuits 316, 318, 320, e.g. matching circuits, terminals, signal processors, amplifiers and communication link transmission devices. The device further comprises a ventilation arrangement 322, comprising an air inlet 324, preferably but not necessary at the bottom part, an air filter 326, which preferably is arranged as a pull-out unit 328 for easy maintenance, a heating element 330 and air outlets 332, 334. The dashed lines depict hidden contours. The air through the ventilation arrangement 322 is brought into movement by one or more fans, preferably placed in the flow path between the air outlets 332, 334 and the air filter 326, or at least between the air inlet 324 and the air outlets 332, 334. An advantage by having the air inlet through the floor of the shelter is that the air temperature is normally lower, and the temperature varies less over time. Another advantage is that under snowy conditions, the air inlet is not covered by snowdrift.

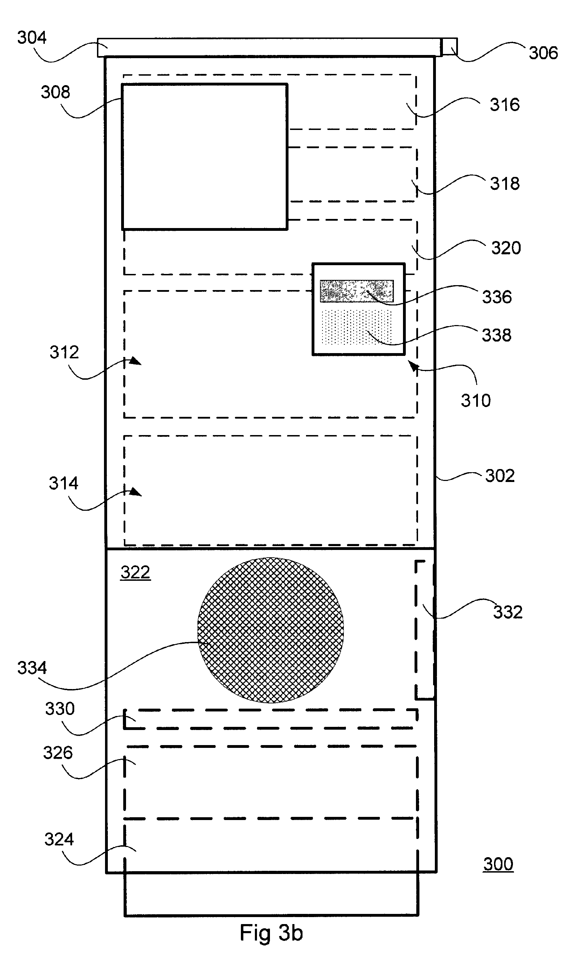

Fig 3b shows the device 300 from another side. The same reference numerals have been used for same parts as in Fig 3a. The dashed lines depict hidden contours. From this view, the AC distribution box 308 and the controller 310 are seen in front view. The controller 310 further comprises a user interface comprising a display 336 and an input device 338, e.g. a keyboard. The controller 310 may control a multitude of things, e.g. temperature and ventilation, DC power supply and battery backup, alarm systems and lighting devices.

Power supply is thus integrated in the device 300 through DC power supply 312 and DC power backup batteries 314. During normal operation, power is provided by the DC power supply 312, and the DC power backup batteries 314 are charged. DC power backup batteries 314 may of course also comprise only one battery, but in many cases it is more convenient to use a plurality of smaller batteries instead of one large, especially when lead accumulators are used, since they are rather heavy, and handling is eased if a plurality of small batteries are used instead of one large. When power supply network supplying the site fails, backup power supply maintains power supply to the controller 310, the fans in the ventilation arrangement 322, and technical equipment connected to the device 300. The miscellaneous circuits are also supplied, if necessary. The controller controls backup power supply, and if the power supply network failure remains, and batteries are starting to run out of power, the site can be taken out of service in a controlled way, eventually handing over to a redundant site, with accurate ventilation all the time. Sudden uncontrolled break-downs of the technical equipment due to power failure or over-heating normally cause trouble at start-up. The present invention will enable temperature control by ventilation during backup power operation. Thus, start-up of the site will be eased, since close-down is made in an appropriate way. The integration of ventilation and power supply is the key to this feature.

By this integrated approach to build-up of necessary facilities needed at most sites comprising technical equipment, the device can be produced in an industrial environment, thus significantly reducing the costs. Further, maintenance is significantly eased, since: parts are exchangeable and the same at all sites using the device; the whole device is exchangeable; and minimized installation in the shelter also eases maintenance. Further, the solution is more robust, since all parts are pre-customised to fit to each other. Flexibility is maintained since parts 316, 318 and 320 may be exchanged to custom parts. Further, an air conditioner (not shown in Fig 3a, 3b) may be integrated in the ventilation arrangement 322. In most cases, this is not needed, since air is taken from under the shelter. As discussed above, this air will provide better cooling in itself. Thus, energy saving is also provided.

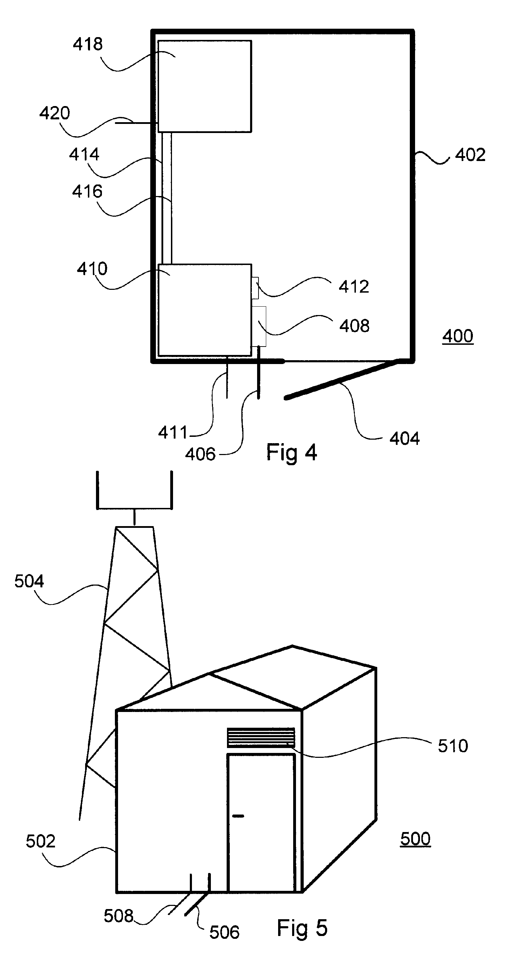

Fig 4 shows an example of an arrangement plan for a site shelter using the device shown in Fig 3a and Fig 3b. The shelter 400 may be built as a small house 402, but may as well be any container. The reduction of components will provide less need for space, thus resulting in more flexible choice of shelter. This will then provide less transports, which may be most beneficiary, since the sites may be located over a wide area, e.g. a country or a whole continent, and not seldom in places difficult to access. The house or container 402 still needs a door 404 and connection to AC power supply network 406, which is connected to the integrated AC distribution box 408 on the device 410. The device 410 also has a connection 411 to a communication network. The controller 412 is preferably located so that it can be accessed in the vicinity of the door 404. In most cases, no internal AC power network is needed. However, an internal DC power network 414 for providing DC power to the technical equipment 418 is needed. An internal communication network 416 or communication line between the device 410 and the technical equipment 418 is preferred. In Fig 4 the technical equipment 418 is depicted as one unit, but may of course also be two or more. The technical equipment 418 preferably has a connection 420 to external equipment.

Fig 5 shows an example of a site 500 comprising a shelter 502 and some external equipment 504. In this example, a mobile communication base station site is depicted for illustrative reasons, with an antenna arrangement as external equipment. However, the same applies for most sites comprising technical equipment, e.g. electricity distribution plants, railway signal towers, telephone exchanges, transmission sites for radio and television broadcasting, private mobile radio network sites, radio repeaters and weather stations. All of these generally comprise some form of technical equipment inside a shelter and some external equipment. The technical equipment normally needs power supply. Therefore, the site has a connection to power supply network 506. Further, for control, or input and output of information, the site has a connection to a communication network 508. In Fig 5 this is depicted as a wired connection for illustrative reasons. However, the connection may as well be wireless. The shelter, equipped with the device described above, has its air inlet through the floor, and it can thus not be seen in Fig 5. An air outlet 510 is provided.

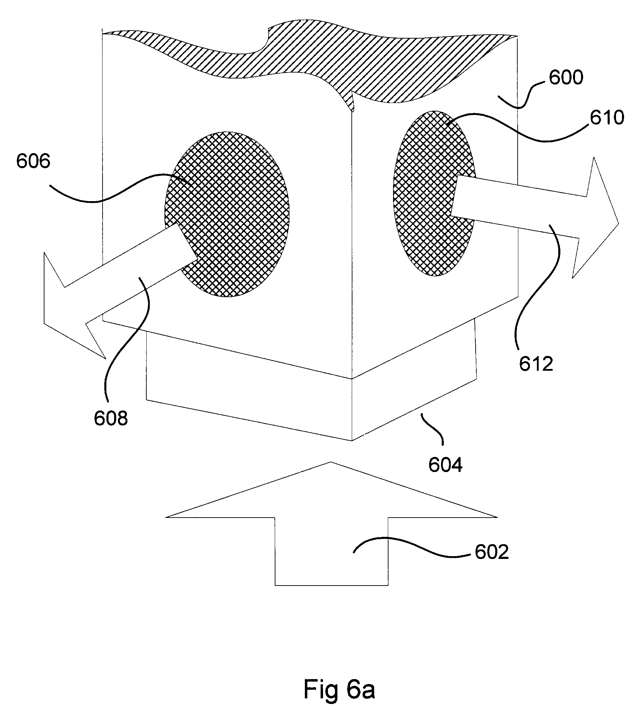

Fig 6a schematically shows the ventilation part 600 of the device depicted in Fig 3a and Fig 3b during operation for normal or maximal cooling. An air inflow 602 through an air inlet is distributed by the ventilation part 600 by a first and a second fan, respectively, through a first air outlet 606 to form a first airflow 608, and a second air outlet 610 to form a second airflow 612, respectively, into the space containing the technical equipment. In this example, there is one air inlet 604 into the ventilation part 600 and there are two air outlets 606, 610 into the space containing the technical equipment. However, there may be one or more air inlets, and there may be one or more air outlets, and there may be one fan driving all airflow or a plurality of fans, e.g. one for each air outlet, or one for each air inlet. The one or more fans are controlled by a controller.

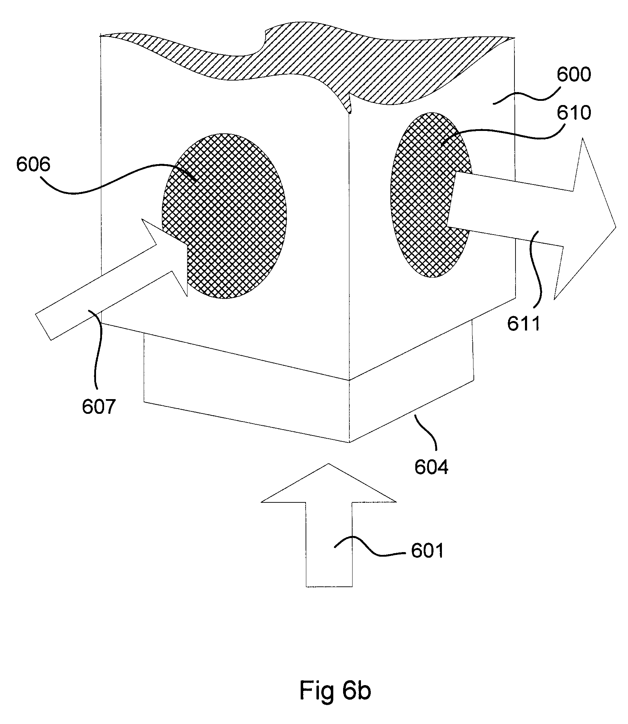

Fig 6b schematically shows the ventilation part 600 of the device depicted in Fig 3a and Fig 3b during operation for cooling when temperature of air at air inlet is very low. There is a risk when the air distributed into the space containing the technical equipment is very low, in that a layer of air with very low temperature is formed in the lower part of the space containing the technical equipment, and a layer of hot air is formed above the low temperature air layer, thus deteriorating the cooling of equipment in the hot air layer. This problem is solved by letting the air inflow 601 through the air inlet distribute by the ventilation part 600 by a first and a second fan, respectively, by letting a first air outlet 606 form a first airflow 607 from the space containing the technical equipment into the ventilation part 600, and a second air outlet 610 form a second airflow 611 into the space containing the technical equipment. One of the air outlets thereby becomes an "air inlet". The operation is controlled by a controller that lets a fan associated with the first air outlet 606 rotate slower than a fan associated with the second air outlet 610. Normally, the fan associated with the first air outlet 606 is stopped while driving the fan associated with the second air outlet at a speed that provides appropriate air distribution into the space containing the technical equipment. The single resistances of the air filter and the first air outlet will cause each of the airflows 601 and 607 to only be a part of the total distributed airflow 611. Further, the single resistance of the first air outlet can be controlled by controlling the fan associated with the first air outlet. Thereby, the grade of re-circulation can be controlled. Alternatively or additionally, one or more dampers are used for controlling the air flow, and thereby also the re-circulation. By re-circulating air from the space containing the technical equipment, the air distributed through air outlet 610 has an appropriate temperature for better cooling of the entire space containing the technical equipment, since layering of air is reduced. In this example, there is one air inlet 604 into the ventilation part 600 and there are two air outlets 606, 610 into the space containing the technical equipment. However, there may be one or more air inlets, and there may be two or more air outlets. In case of more than two air outlets, at least one of the fans associated with the air outlets should be stopped, or driven at a lower speed than at least one of the other fans, to provide re-circulation.

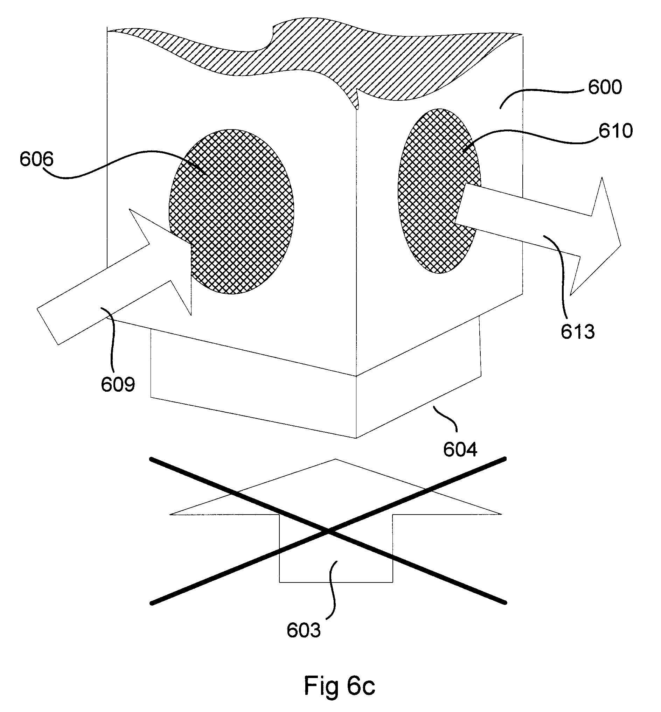

Fig 6c schematically shows the ventilation part 600 of the device depicted in Fig 3a and Fig 3b during operation for cooling when temperature of air at air inlet is very low, and/or low cooling effect is needed. The airflow 603 through the air inlet 604 is then essentially zero. By letting a first air outlet 606 form a first airflow 609 from the space containing the technical equipment into the ventilation part 600, and a second air outlet 610 form a second airflow 613 into the space containing the technical equipment, total re-circulation is provided. One of the air outlets thereby becomes an "air inlet". The operation is controlled by a controller that lets a fan associated with the first air outlet 606 rotate in opposite direction in relation to normal or maximal cooling. Alternatively, the fan associated with the first air outlet 606 is stopped while driving the fan associated with the second air outlet at a speed that provides appropriate air distribution into the space containing the technical equipment. The single resistance of the air filter will cause the airflow 603 to be close to zero when driving the fans in an appropriate way. In this example, there is one air inlet 604 into the ventilation part 600 and there are two air outlets 606, 610 into the space containing the technical equipment. However, there may be one or more air inlets, and there may be two or more air outlets. In case of more than two air outlets, at least one of the fans associated with the air outlets should be driven in opposite direction, or stopped, to provide re-circulation, while driving at least one fan in normal direction, all related to directions during normal or maximal cooling. Alternatively or additionally, one or more dampers is used for controlling the air flow, and thereby also the re-circulation.

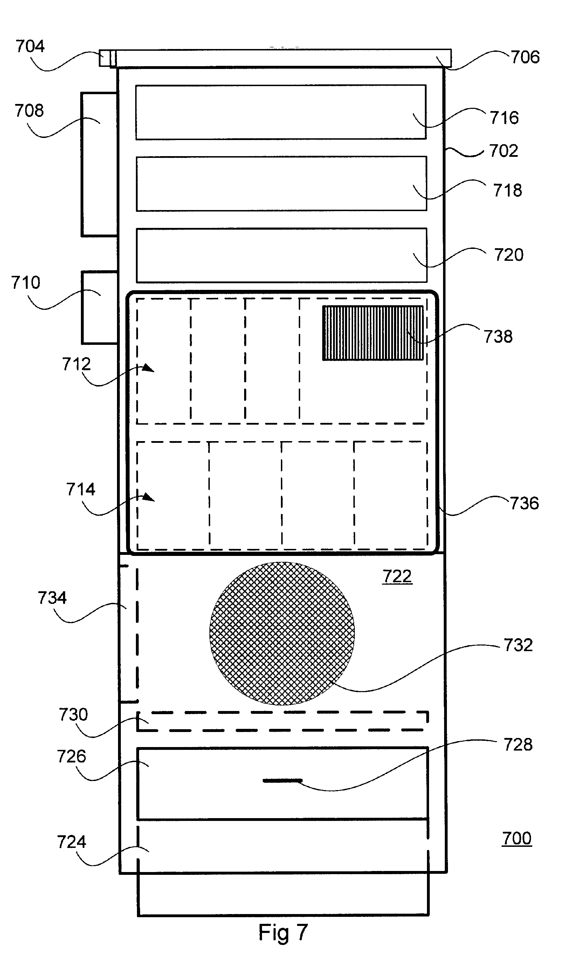

Most electric and electronic equipment have a specified range of operation temperature, e.g. between 0 and 70 degrees centigrade (representative for many integrated circuits). However, some equipment has a life expectancy very much dependent on temperature, e.g. lead accumulators which will provide significantly better endurance if they are kept below 25 degrees centigrade. Fig 7 shows an alternative embodiment of the device depicted in Fig 3a. A device 700 with a framework 702 preferably comprises a cabinet for e.g. 19" rack. The framework 702 may hold lighting devices 704, 706, AC distribution box 708, controller 710, DC power supplies 712, DC power backup batteries 714, miscellaneous circuits 716, 718, 720, e.g. matching circuits, terminals, signal processors, amplifiers and communication link transmission devices. The device further comprises a ventilation arrangement 722, comprising an air inlet 724, preferably but not necessary at the bottom part, an air filter 726 which preferably is arranged as a pull-out unit 728 for easy maintenance, a heating element 730, and air outlets 732, 734. The dashed lines depict hidden contours. A container 736, which constitutes a part of the device 700, is thermally sealed off from the rest of the device 700, and thus from the rest of the space containing the technical equipment. Thereby different temperature zones may be provided. Components that have more narrow temperature requirements are placed in the container 736. A temperature regulating means 738 is provided at the container 736. The temperature regulating means 738 may comprise a small air conditioner, or preferably a peltier element. A peltier element has the advantage that it has low maintenance requirements, and it can provide both cooling and heating. Thus, the temperature may be kept within a narrower range within the container 736. As an example, the temperature in the space containing the technical equipment is kept between 10 and 50 degrees centigrade, while the temperature in the container 736 is kept between 15 and 25 degrees centigrade. By placing e.g. the lead accumulators in the container, their life expectancy is significantly prolonged, while by raising the upper temperature limit in the rest of the space, the energy consumption for cooling is significantly decreased.

## Claims

1. A device for temperature control in a space containing technical equipment, the device comprising
an air inlet;
an air filter arranged to filter air taken in through the air inlet;
one or more air outlets discharging in the space containing technical equipment;
one or more fans arranged in a flow path between the air inlet and said one or more air outlets, wherein
the air filter, said one or more air outlets, and said one or more fans are arranged in the device together with a controller and a power supply, wherein
the controller is arranged to control said one or more fans, and wherein
the power supply is arranged to power supply the controller, said one or more fans, and at least one piece of technical equipment contained in the space containing technical equipment.

2. A device according to claim 1, further comprising a heating means in the flow path between the air inlet and said one or more air outlets.

3. A device according to any of claims 1 or 2, further comprising an air conditioning means.

4. A device according to any of claims 1-3, further comprising means for re-circulating at least a part of the air in the space for technical equipment.

5. A device according to claim 4, wherein said means for re-circulation comprises a damper for controlling air flow.

6. A device according to any of claims 4 or 5, wherein said one or more fans comprise two or more fans, said means for re-circulating at least a part of the air in the space for technical equipment comprising said two or more fans, wherein at least one of said two or more fans are arranged to be driven at a lower speed than at least another of said two or more fans.

7. A device according to claim 6, wherein said lower speed is essentially zero.

8. A device according to claim 6, wherein said lower speed includes that said at least one fan is driven in opposite direction compared to non-re-circulating operation.

9. A device according to any of claims 1-8, comprising one or more temperature sensors measuring air temperature, wherein the controller controls said one or more fans depending on at least one output from said one or more temperature sensors.

10. A device according to any of claims 1-9, wherein said at least one piece of technical equipment contained in the space containing technical equipment comprises telecommunication equipment.

11. A device according to any of claims 1-10, further comprising any of the following means arranged to interact with technical equipment contained in the space containing technical equipment:
a link transmission unit, a signal processing means, a matching circuit, a connection terminal board, and an antenna signal amplifier.

12. A device according to any of claims 1-11, further comprising a container arranged to keep a narrower temperature range compared to a temperature range kept in the space containing technical equipment.

13. A device according to claim 12, wherein the container comprises a peltier element.

14. A device according to any of claims 12 or 13, wherein a lead accumulator is placed in the container.

15. A device according to any of claims 1-14, wherein the power supply comprises a network power supply and a backup power supply.

16. A device according to claim 15, wherein the device and said at least one piece of technical equipment are powered by the network power supply when operating in a first power supply mode, and the device and said at least one piece of technical equipment are powered by the backup power supply when operating in a second power supply mode.

17. A device according to claim 16, wherein the backup power supply comprises one or more batteries, and said one or more batteries are charged by the network power supply when operating in the first power supply mode.

18. A device according to any of claims 16 or 17, wherein the controller is arranged to control power supply when operating in the second power supply mode, and to shut down equipment powered by the backup power supply in a controlled way if the backup power supply runs out of power.

19. A device according to any of claims 1-18, wherein the air inlet is at a bottom of the device.

20. A method for temperature control in a space containing technical equipment, the method comprising the steps of:
taking in air through an air inlet;
filtering the air with an air filter;
distributing the air in the space containing technical equipment through one or more air outlets by one or more fans;
controlling said one or more fans with a controller; and
supplying power to the controller, said one or more fans and at least one piece of technical equipment contained in the space for technical equipment by a power supply,
wherein said steps of taking in, filtering, distributing, controlling, and supplying power are performed by one single device that comprises said air inlet, air filter, one or more air outlets, one or more fans, controller, and power supply.

21. A method according to claim 20, further comprising the steps of:
measuring a first air temperature in the space for technical equipment;
heating air with a heater arranged in a flow path of the air flowing between the air inlet and said one or more air outlets if said first air temperature is below a first threshold level; and
distributing the heated air in the space for technical equipment with at least one of said one or more fans.

22. A method according to any of claims 20 or 21, further comprising the steps of:
measuring a second air temperature at the air inlet; and
re-circulating air from the space containing technical equipment if said second air temperature is below a second threshold level.

23. A method according to claim 22, wherein said one or more fans comprise two or more fans, further comprising the steps of:
driving one of said two or more fans at a lower speed; and
driving another one of said two or more fans at a higher speed.

24. A method according to claim 23, wherein said lower speed is essentially zero.

25. A method according to claim 23, wherein said lower speed includes that said at least one fan is driven in opposite direction compared to non-re-circulating operation.

26. A method according to any of claims 20 to 25, wherein the device comprises a container, further comprising the steps of:
controlling the temperature in the space containing technical equipment to be within a first temperature range; and
controlling the temperature in the container to be within a second temperature range, wherein the second temperature range is narrower than the first temperature range.
